# EUROPÄISCHE PATENTSCHRIFT

(11) **EP 0 989 677 B1**
(45) Veröffentlichungstag und Bekanntmachung des Hinweises auf die Patenterteilung: **04.05.2005**
(21) Anmeldenummer: 99111967.8
(22) Anmeldetag: 25.06.1999
(51) Int. Cl.: H03M 1/14, H01H 19/56, H03M 1/28

(54) **Kodierer zur Umwandlung einer analogen Eingabe in Digitalsignale**
Encoder for converting an analogue input to digital signals
Codeur pour la conversion d'une entrée analogique en signaux numériques

(30) Priorität: 21.09.1998 DE 19843143
(43) Veröffentlichungstag der Anmeldung: 29.03.2000
(73) Patentinhaber: Viessmann Werke GmbH & Co KG, 35107 Allendorf (DE)
(72) Erfinder: Gücker, Ludolf, 35116 Reddighausen (DE)
(74) Vertreter: Beetz & Partner Patentanwälte

(56) Entgegenhaltungen:
- DE-A- 3 236 286
- DE-A- 3 240 547
- WOOLVET G A: "DIGITAL TRANSDUCERS" JOURNAL OF PHYSICS E. SCIENTIFIC INSTRUMENTS, IOP PUBLISHING, BRISTOL, GB, Bd. 15, Nr. 12, 1982, Seiten 1271-1280, XP002055470 ISSN: 0022-3735

## Beschreibung

Die Erfindung betrifft einen Kodierer zur Umwandlung einer analogen Eingabe in Digitalsignale und insbesondere einen Drehschalter zur Einstellung von Sollwerten für Heizungsregelungen, der eine hohe Funktionssicherheit und eine geringe Baugröße aufweist.

Gemäß dem Stand der Technik sind Drehschalter zur vorzugsweisen Einstellung von Sollwerten für Regelungen bekannt. Dem jeweiligen Benutzer soll es ermöglicht werden, eine Einstellung mit einer analogen Skala vorzunehmen, wobei dann digitale Signale direkt an eine Auswerteelektronik weitergeleitet werden. Sollen etwa 28 Einstellschritte über einen digitalen Signalausgang realisiert werden, so wird eine Auflösung von 5 Bit benötigt. Zur Realisierung dieser Auflösung sind üblicherweise sechs Kontaktfinger nötig.

Eine hohe Anzahl von Kontaktfingern ergibt zunächst eine relativ große Baugröße und weiterhin sinkt mit jedem Kontaktfinger die Funktionssicherheit.

Die Druckschrift DE 3240547 A1 zeigt eine Schaltungsanordnung zum Umschalten der Leistungszufuhr zu elektrischen Verbrauchern, wobei eine zumindest eingeschränkte Nutzung der Anordnung auch bei einem Ausfall der elektronischen Bausteine möglich ist. Dies wird dadurch erreicht, dass an einer Kontaktbahn ein zusätzlicher Schaltkontakt vorgesehen ist, wobei über diesen zusätzlichen Schaltkontakt ein Verbraucher auch bei einem Ausfall der Dekodier-Leistungssteuerschaltung noch ein- und ausgeschaltet werden kann, so dass eine zumindest eingeschränkte Nutzung der Anordnung ermöglicht wird.

Aufgabe der Erfindung ist es einen Kodierer zur Umwandlung einer analogen Eingabe in Digitalsignale zu schaffen, der eine geringe Baugröße und eine reduzierte Störanfälligkeit aufweist.

Die Aufgabe wird gemäß den Merkmalen des unabhängigen Patentanspruchs gelöst. Die abhängigen Patentansprüche zeigen vorteilhafte Ausführungsformen und Weiterentwicklungen der Erfindung auf.

Erfindungsgemäß ist ein Kodierer zur Umwandlung einer analogen Eingabe in Digitalsignale vorgesehen, der eine vorbestimmte Anzahl von Kontaktfingern und eine vorbestimmte Anzahl von Bahnen aufweisen kann, wobei die Anzahl der Kontaktfinger der Anzahl der vorgesehenen Bahnen entspricht. Die Anzahl der Kontaktfinger kann der Anzahl der Bahnen entsprechen, wobei jedoch angemerkt werden soll, daß dies nicht eine Bedingung für das Funktionieren der Erfindung ist. Weiterhin kann die Anzahl der Kontaktfinger und damit die Anzahl der Bahnen ≥ 2 sein.

Erfindungsgemäß können weiterhin Mittel vorgesehen sein, die eine Spannung zwischen den Kontaktfingern und Kontaktfeldern anlegen, die den Bahnen zugeordnet sind. Weiterhin kann eine Auswerteeinheit vorgesehen sein, zur Auswertung der analogen Einstellung über eine Erfassung eines Stromflusses zwischen zumindest einem Kontaktfinger und einem Kontaktfeld, wobei zumindest eine Bahn zumindest zwei Kontaktfelder aufweisen kann, die zueinander elektrisch isoliert sind und über getrennte Leitungen mit der Auswerteeinheit verbunden sind und wobei zumindest eine Bahn zumindest zwei Kontaktfelder aufweisen kann, die elektrisch miteinander verbunden sind und weiterhin über eine Leitung mit der Auswerteeinheit verbunden sind.

Durch die erfindungsgemäße Ausgestaltung und insbesondere dadurch, daß die Kontaktfelder einer Bahn elektrisch voneinander isoliert sind ist es möglich, einen Kodierer zu schaffen, welcher bei gleichem Platzbedarf, verglichen mit einem üblichen Kodierer mit der gleichen Anzahl von Bahnen, eine höhere Abstufung der Einstellschritte ermöglicht. Wie oben schon erwähnt, kann das dadurch erreicht werden, daß beispielsweise eine Bahn mehrere Bits repräsentiert.

Erfindungsgemäß kann dadurch der Durchmesser eines Drehschalters reduziert werden und die Störanfälligkeit wird stark herabgesetzt, da beispielsweise für 28 Einstellschritte nunmehr nur noch 4 Kontaktfinger nötig sind (im Vergleich zu 6 Kontaktfingern gemäß dem Stand der Technik).

Erfindungsgemäß können die Bahnen auf einer Leiterplatte ausgebildet sein und rotationssymmetrisch um eine Achse A angeordnet werden. Durch eine derartige Anordnung kann ein sehr platzsparender Kodierer realisiert werden und es ist möglich, mehrere Bauelemente zusammen mit dem Kodierer in einem Arbeits- bzw. Herstellungsvorgang zu produzieren.

Weiterhin können die Kontaktfinger an einer Kontaktgabel angeordnet sein, wobei dann die Kontaktgabel wiederum mit einem Mitnehmer in Verbindung steht, welcher um die Achse A drehbar ist, so daß sich die Kontaktfinger bei einer Drehbewegung des Mitnehmers über die Bahnen und damit über die an den Bahnen vorgesehenen Kontaktfelder bewegen können.

An dieser Stelle sei angemerkt, daß natürlich anstatt der rotationssymmetrischen Anordnung der Bahnen auch eine Anordnung derselben in Längsrichtung denkbar ist. Die Kontaktfinger müßten dann in Längsrichtung bewegt werden, um in Kontakt mit den Kontaktfeldern zu kommen. Weiterhin wäre es denkbar, die Bahnen etwa an der Innenseite einer Trommel vorzusehen, wobei dann entweder die Kontaktfinger entlang der Innenseite der Trommel bewegt werden würden oder die Trommel würde bei feststehenden Kontaktfingern bewegt werden.

Erfindungsgemäß erfolgt eine Stromleitung zwischen dem jeweiligen Kontaktfinger und dem Kontaktfeld, mit dem der Kontaktfinger mechanisch in Kontakt kommt. Aus dem entsprechenden Stromfluß und der zugeordneten Position des Kodierers kann über eine entsprechende Wahrheitstabelle durch die Auswerteeinheit ein Digitalsignal an eine entsprechend vorgesehene Recheneinheit ausgegeben werden.

Um es dem Benutzer beim Einstellen des Kodierers zu erleichtern gewünschte Analogwerte einzustellen, können entsprechende Rastmittel vorgesehen sein, welche ein Einstellen des Kodierers erleichtern.

Weiterhin kann erfindungsgemäß ein Zwei-Bit-Encoder realisiert werden, welcher auf dem gleichen Funktionsprinzip beruht.

Neben dem oben erwähnten Kontaktprinzip zwischen dem jeweiligen Kontaktfinger und den Kontaktfeldern, welche in bzw. auf entsprechenden Bahnen angeordnet sind und über einen mechanischen Kontakt einen Stromfluß ermöglichen, können natürlich auch andere Positionserkennungsprinzipien angewendet werden. Zum einen wäre etwa eine optische Positionserkennung mit einer Leuchtdiode und einem Lichterkennungssensor denkbar. Über entsprechende induktive Erkennungsmethoden, beispielsweise mit einem Hall-Sensor, könnte ebenso eine Kodierung vorgenommen werden.

Anstatt des oben erwähnten rotationssymmetrischen Anordnen der Bahnen (Drehkodierer) könnte etwa auch ein Schiebekodierer mit dem gleichen erfindungsgemäßen Prinzip in vorteilhafter Weise realisiert werden. Hierbei wären die Bahnen längs angeordnet. Denkbar wäre es weiterhin einen Kodierer zu schaffen, der durch Drücken etwa auf einen vorgesehenen Knopf oder einen Hebel diese Bewegung in Digitalsignale umsetzt. Die Bahnen wären dann beispielsweise an der Außenwand des Knopfs vorgesehen und würden sich an entsprechenden Kontaktfingern vorbeibewegen.

Im folgenden werden Ausführungsbeispiele der Erfindung anhand von schematischen Zeichnungen näher erläutert. Es zeigen:
- Fig. 1: Eine Explosionsdarstellung eines Kodierers gemäß der Erfindung;
- Fig. 2: ein Beispiel einer Anordnung von Kontaktfeldern in Kontaktbahnen und das zugehörige Bitmuster und
- Fig. 3: ein Beispiel eines Bitmusters für einen Zwei-Bit-Encoder.

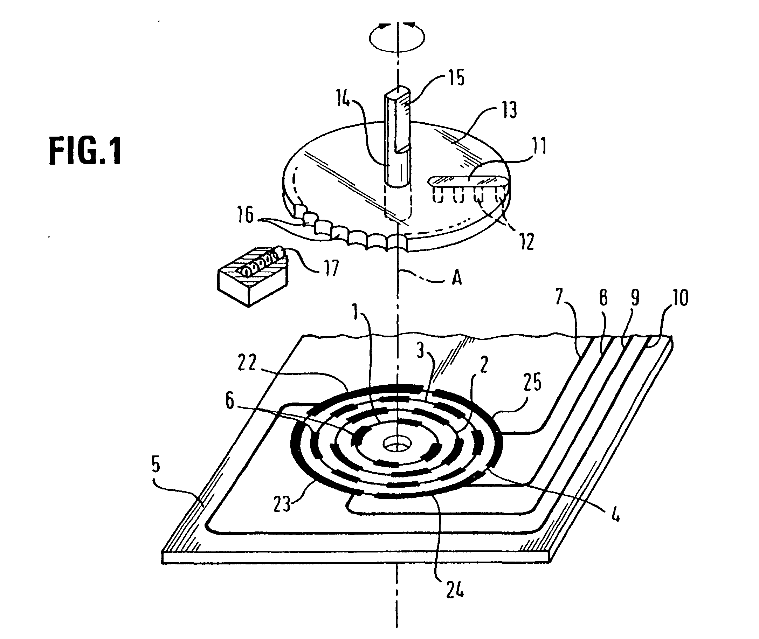

Die Fig. 1 zeigt eine Leiterplatte 5, auf der vier Bahnen 1, 2, 3 und 4 rotationssymmetrisch um eine Achse A angeordnet sind.

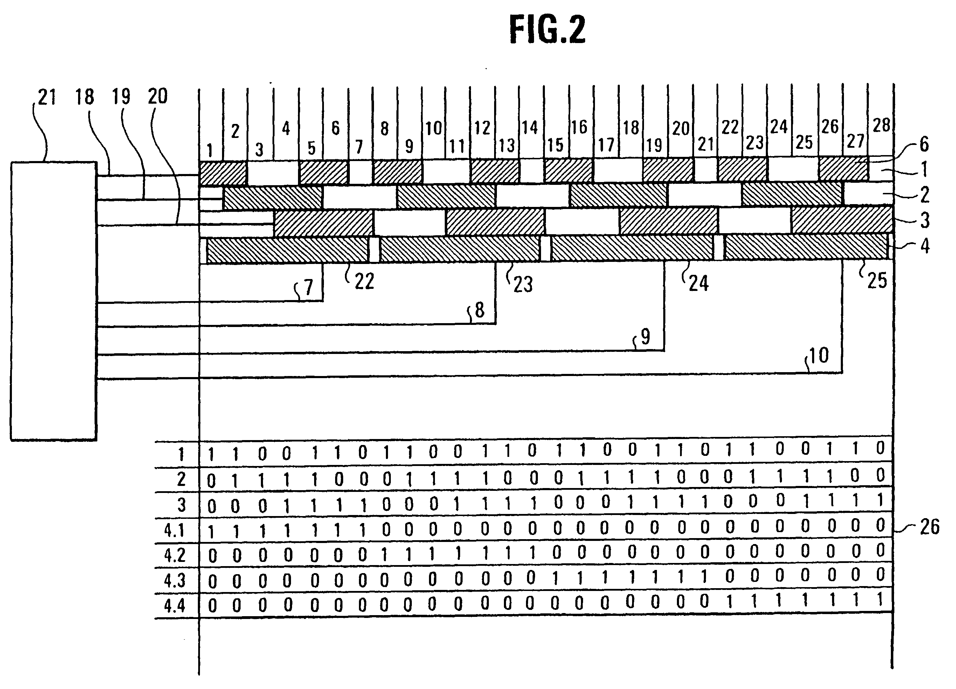

Die Bahnen weisen eine vorbestimmte Anzahl von Kontaktfeldern 6, 22, 23, 24, 25 auf. Die Kontaktfelder 6 der Bahn 1 sind elektrisch miteinander verbunden und weiterhin mit einer Auswerteeinheit (siehe Fig. 2). Das gleiche gilt für die Kontaktfelder 6 der Bahnen 2 und 3. Die Kontaktfelder 22, 23, 24, 25 der Bahn 4 weisen jeweils eine eigene Leitung 7, 8, 9 und 10 auf. Die in dieser Figur dargestellten Leitungen führen zu der Auswerteeinheit.

Der Kodierer weist weiterhin eine Kontaktgabel 11 auf, an der Kontaktfinger 12 vorgesehen sind. Die Kontaktgabel 11 ist an einem Mitnehmer 13 vorgesehen, welcher um die Achse A drehbar ist. An dem Mitnehmer 13 ist eine Welle 14 vorgesehen, die an dem dem Mitnehmer 13 gegenüberliegenden Ende eine Abflachung 15 aufweist. Die Abflachung 15 dient zum positionsgenauen Aufstecken eines nicht dargestellten Drehknopfes, welcher vom Benutzer betätigt werden kann.

Der Mitnehmer 13 weist weiterhin Einbuchtungen 16 auf, in welche ein Rastmittel 17 eingreifen kann. Das Rastmittel 17 kann etwa eine Kugel sein, welche über eine Feder vorgespannt ist. Die Einbuchtungen 16 im Zusammenhang mit dem Rastmittel 17 können eine positionsgenaue Verdrehung des Mitnehmers 13 ermöglichen. Wird nun der Mitnehmer über die Welle 14 gedreht, so werden die Kontaktfinger 12 über die Bahnen 1, 2, 3 und 4 bewegt. Hierbei treten die Kontaktfinger mit den an den Bahnen 1, 2, 3 und 4 angeordneten Kontaktfeldern 6, 22, 23, 24 und 25 in Kontakt, wodurch es zu einem entsprechenden Stromfluß kommt. Dieser Stromfluß kann dann von der Auswertereinheit erfaßt und entsprechend einer Wahrheitstabelle 26 ausgewertet werden.

Die Fig. 2 zeigt eine schematische Darstellung der Bahnen 1, 2, 3 und 4. Die Bahn 1 ist über eine Leitung 18 mit einer Auswerteeinheit 21 verbunden. Die Bahn 2 ist über eine Leitung 19 und die Bahn 3 über eine Leitung 20 mit der Auswerteeinheit 21 elektrisch verbunden.

Die Bahn 4 enthält in diesem Beispiel vier Kontaktfelder 22, 23, 24 und 25. Diese Kontaktfelder 22, 23, 24 und 25 sind über die Leitungen 7, 8, 9 und 10 jeweils einzeln mit der Auswerteeinheit 21 verbunden.

Weiterhin ist in der Fig. 2 eine Einteilung des Kodierers in 28 Stellungen dargestellt. Über eine in der unteren Hälfte der Fig. 2 dargestellte Warheitstabelle 26 kann nun die Auswerteeinheit 21 jede Stellung in einen Digitalwert umwandeln. In diesem Fall hätte der Mitnehmer 13 28 Einbuchtungen 16. Jeder Raststellung des Mitnehmers 13 entspricht einer exakt definierten Position der Kontaktfinger 12 auf den Bahnen 1, 2, 3 und 4 und damit auf den Kontaktfeldern 6, 22, 23, 24 und 25. Würde etwa die Kontaktgabel 11 mit den vier Kontaktfingern 12 die Position "1" einnehmen, so würde sich der Kontaktfinger "1" (der Kontaktfinger 12, welcher der Bahn 1 zugeordnet ist) auf einem Kontaktfeld 6 befinden. Der Kontaktfinger "2", welcher der Bahn 2 zugeordnet ist und der Kontaktfinger "3", der der Bahn 3 zugeordnet ist würden sich nicht auf einem Kontaktfeld 6 befinden. Der Kontaktfinger "4", welcher der Bahn 4 zugeordnet ist würde sich auf dem Kontaktfeld 22 befinden. Über die Kontaktfinger 12 und insbesonder über die Kontaktfinger "1" und "4" kann nun ein Stromfluß über die entsprechenden Kontaktfelder 6 und 22 erfolgen, und zwar über die Leitungen 18 und 7. Die Auswerteeinheit 21 erfaßt somit einen Binärcode 1001000 (siehe untere Darstellung der Fig. 2). Wie aus der Wahrheitstabelle 22 der Fig. 2 entnehmbar ist, hat jede der 28 Stellungen einen unterschiedlichen Binärcode, welcher über die Auswerteeinheit 21 und die entsprechenden Leitungen 7, 8, 9, 10, 18, 19 und 20 ausgewertet werden kann.

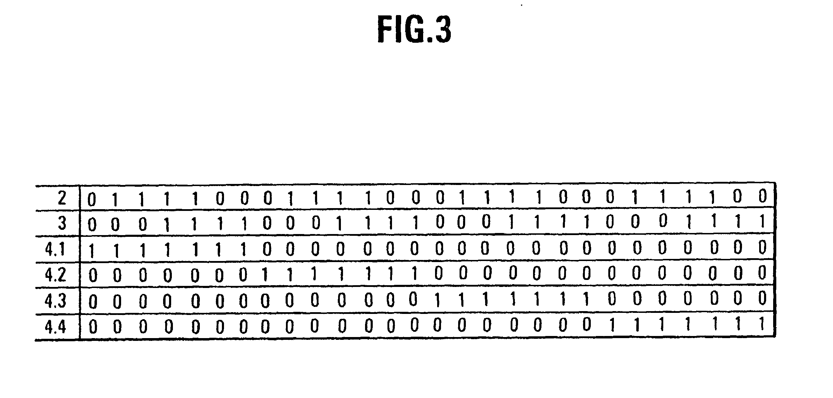

Die Fig. 3 zeigt eine Abwandlung des vorgenannten Kodierers, nämlich einen 2-Bit-Encoder. Die Kontaktfelder 22, 23, 24 und 25 werden als gleiches Potential angesehen. Gemäß dieser Ausführungsform könnte etwa eine Drehung eines Drehschalters um 360° in acht Schritte aufgeteilt werden. Der Kodierer könnte beispielsweise zwischen einer Rechtsdrehung und einer Linksdrehung unterscheiden, und zwar durch eine Versetzung der Bahnen 2 und 3 zueinander. Bei einer Rechtsdrehung kommt das Kontaktfeld 6 der Bahn 2 zuerst, so daß von der Bahn 2 zuerst ein Signal von der Auswerteeinheit 21 erfaßt wird. Dadurch kann auf eine Rechtsdrehung geschlossen werden. Bei einer Linksdrehung kommt der entsprechende Kontaktfinger 12 zuerst mit einem Kontaktfeld 6 der Bahn 3 in Kontakt, so daß die Auswerteeinheit 21 dadurch auf eine Linksdrehung schließen kann.

Der erfindungsgemäße Kodierer kann beispielsweise zum Einstellen von Sollwerten für Heizungsregelungen verwendet werden. Weiterhin kann der Kodierer als Drehschalter ausgebildet sein. Es sei jedoch ausdrücklich angemerkt, daß die Erfindung nicht auf diese Anwendungen und auf diese Ausgestaltung beschränkt ist. Selbstverständlich kann die Erfindung in allen Gebieten eingesetzt werden, in denen eine analoge Bewegung in ein Digitalsignal umgesetzt werden soll.

## Patentansprüche

1. Kodierer zur Umwandlung einer analogen Eingabe in Digitalsignale, mit
- einer vorbestimmten Anzahl Nk ≥ 2 Kontaktfingern (12),
- einer vorbestimmten Anzahl Nb ≥ 2 Bahnen (1, 2, 3, 4), wobei Nk = Nb,
- Mitteln zum Anlegen einer Spannung zwischen den Kontaktfingem (12) und an den Bahnen (1, 2, 3, 4) zugeordneten Kontaktfeldern (6, 22, 23, 24, 25), und
- einer Auswerteeinheit (21) zur Auswertung der analogen Einstellung über eine Erfassung eines Stromflusses zwischen zumindest einem Kontaktfinger (12) und zumindest einem Kotaktfeld (6), wobei
zumindest eine Bahn (4) zumindest zwei Kontaktfelder (22, 23, 24, 25) aufweist, die zueinander elektrisch isoliert sind und über getrennte Leitungen (7, 8, 9, 10) mit der Auswerteeinheit (21) verbunden sind und wobei zumindest eine andere Bahn (1, 2, 3) zumindest zwei Kontaktfelder (6) aufweist, die elektrisch miteinander und über eine Leitung (18, 19, 20) mit der Auswerteeinheit (21) verbunden sind,
**dadurch gekennzeichnet, dass**
die Bahnen (1, 2, 3, 4) ein Bitmuster repräsentieren, das in der Auswerteeinheit (21) über eine Wahrheitstabelle (26) in einen eine Stellung angebenden Digitalwert umgewandelt wird.

2. Kodierer nach Anspruch 1, dgd die Bahnen (1, 2, 3 und 4) auf einer Leiterplatte (5) ausgebildet sind.

3. Kodierer nach Anspruch 1 oder 2, dgd die Bahnen (1, 2, 3, 4) rotationssymmetrisch bezüglich einer Achse A zueinander in einer Ebene angeordnet sind.

4. Kodierer nach zumindest einem der Ansprüche 1 bis 3, dgd die Kontaktfinger (12) derart drehbar um die Achse A angeordnet sind, daß sie in der Lage sind, über die Bahnen (1, 2, 3, 4) zu laufen, wobei jeweils einer Bahn (1, 2, 3, 4) ein Kontaktfinger (12) zugeordnet ist.

5. Kodierer nach zumindest einem der Ansprüche 1 bis 4, **dadurch gekennzeichnet, daß** die Kontaktfinger (12) an einer Kontaktgabel (11) angeordnet sind und die Kontaktgabel (11) an einem Mitnehmer (13), der um die Achse A drehbar ist.

6. Kodierer nach zumindest einem der Ansprüche 1 bis 5, **dadurch gekennzeichnet, daß** Rastmittel (17) vorgesehen sind, die eine schrittweise Bewegung des Mitnehmers (13) ermöglichen, so daß die Kontaktfinger (12) bei jeder Rastung um ein äquidistantes Drehwinkelinkrement weiterbewegt werden und dabei jeweils vordefinierte Positionen auf den Bahnen (1, 2, 3, 4) einnehmen.

7. Kodierer nach zumindest einem der Ansprüche 1 bis 6, **dadurch gekennzeichnet, daß** die Kontaktfelder (6, 22, 23, 24, 25) auf den Bahnen (1, 2, 3 und 4) gemäß einer vordefinierten Warheitstabelle (26) angeordnet sind.

8. Kodierer nach zumindest einem der Ansprüche 1 bis 7, **dadurch gekennzeichnet, daß** vier Bahnen (1, 2, 3, 4) und vier Kontaktfinger (12) vorgesehen sind, wobei drei Bahnen (1, 2, 3) jeweils Kontaktfelder (6) aufweisen, die miteinander elektrisch verbunden sind und eine Bahn (4) vorgesehen ist, die vier Kontaktfelder (22, 23, 24, 25) aufweist, die elektrisch zueinander isoliert und jeweils einzeln mit der Auswerteeinheit (21) verbunden sind.

9. Kodierer nach zumindest einem der Ansprüche 1 bis 8, **dadurch gekennzeichnet, dass** die Auswerteeinheit (21) mit vier Bahnen (1, 2, 3, 4) und vier Kontaktfingern (12) 28 Schaltstellungen erfassen kann, wobei eine Bahn (1, 2, 3, 4) mehrere Bits repräsentiert.

10. Kodierer nach zumindest einem der Ansprüche 1 bis 7, **dadurch gekennzeichnet, daß** ein Bitgeber dadurch realisiert wird, daß die Kontaktfelder (6) der Bahnen (2, 3) zueinander versetzt sind und die Auswerteeinheit (21) daraus eine Links- oder Rechtsdrehung erfassen kann.

11. Kodierer nach zumindest einem der Ansprüche 1 bis 10, **dadurch gekennzeichnet, daß** der Kodierer als Drehschalter ausgebildet ist.

## Claims

1. Encoder for converting an analogue input to digital signals, comprising:
- a predetermined number Nk ≥ 2 of contact fingers (12),
- a predetermined number Nb ≥ 2 of paths (1, 2, 3, 4), with Nk = Nb,
- means for applying a voltage between the contact fingers (12) and contact banks (6, 22, 23, 24, 25) associated with the paths (1, 2, 3, 4), and
- an evaluation unit (21) for evaluating the analogue adjustment by detecting a current flow between at least one contact finger (12) and at least one contact bank (6), wherein at least one path (4) includes at least two contact banks (22, 23, 24, 25) electrically insulated with respect to each other and connected to the evaluation unit (21) via separate lines (7, 8, 9, 10), and at least one other path (1, 2, 3) includes two contact banks (6) electrically connected to each other and the evaluation unit (21) via a line (18, 19, 20), **characterized in that**
- the paths (1, 2, 3, 4) represent a bit pattern which is converted to a digital value indicating a position via a truth-table (26) in the evaluation unit (21).

2. The encoder according to claim 1, **characterized in that** the paths (1, 2, 3 and 4) are formed on a circuit board (5).

3. The encoder according to claim 1 or 2, **characterized in that** the paths (1, 2, 3, 4) are arranged in a plane in a rotationally symmetrical manner relative to each other with respect to an axis A.

4. The encoder according to at least one of claims 1 to 3, **characterized in that** the contact fingers (12) are arranged rotatably about the axis A such that they are capable of running over the paths (1, 2, 3, 4), with one contact finger (12) being respectively associated with one path (1, 2, 3, 4).

5. The encoder according to at least one of claims 1 to 4, **characterized in that** the contact fingers (12) are disposed on a contact fork (11) and the contact fork (11) is disposed on an engaging device (13) which is rotatable about the axis A.

6. The encoder according to at least one of claims 1 to 5, **characterized in that** snap-in locking means (17) are provided which enable a step-wise movement of the engaging device (13) so that with each locking the contact fingers (12) are moved on by an equidistant rotation angle increment, assuming respective predetermined positions on the paths (1, 2, 3, 4).

7. The encoder according to at least one of claims 1 to 6, **characterized in that** the contact banks (6, 22, 23, 24, 25) are arranged on the paths (1, 2, 3 and 4) according to a predetermined truth-table (26).

8. The encoder according to at least one of claims 1 to 7, **characterized in that** four paths (1, 2, 3, 4) and four contact fingers (12) are provided, wherein three paths (1, 2, 3) respectively include contact banks (6) which are electrically connected to each other, and one path (4) is provided which includes four contact banks (22, 23, 24, 25) which are electrically insulated with respect to each other and respectively connected individually to the evaluation unit (21).

9. The encoder according to at least of claims 1 to 8, **characterized in that** the evaluation unit (21) can detect 28 switching positions with four paths (1, 2, 3, 4) and four contact fingers (12), with one path (1, 2, 3, 4) representing a plurality of bits.

10. The encoder according to at least of claims 1 to 7, **characterized in that** a bit transmitter is realized by the contact banks (6) of the paths (2, 3) being staggered in relation to each other and the evaluation unit (21) being capable of detecting a counterclockwise rotation or clockwise rotation therefrom.

11. The encoder according to at least one of claims 1 to 10, **characterized in that** the encoder is in the form of a rotary switch.

## Revendications

1. Codeur pour la conversion d'une entrée analogique en signaux numériques, avec
- un nombre prédéterminé Nk ≥ 2 doigts de contact (12),
- avec un nombre prédéterminé Nb ≥ 2 trajectoires (1, 2, 3, 4), Nk étant = à Nb,
- avec des moyens pour établir une tension entre les doigts de contact (12) et aux champs de contact (6, 22, 23, 24, 25) attribués aux trajectoires (1, 2, 3, 4), et
- avec une unité d'évaluation (21) pour évaluer le réglage analogique par le biais d'un enregistrement d'un flux de courant entre au moins un doigt de contact (12) et au moins un champ de contact (6),
sachant qu'au moins une trajectoire (4) comporte au moins deux champs de contact (22, 23, 24, 25) qui sont isolés électriquement les uns par rapport aux autres et qui sont reliés à l'unité d'évaluation (21) via des lignes séparées (7, 8, 9, 10) et sachant qu'au moins une autre trajectoire (1, 2, 3) comporte au moins deux champs de contact (6) qui sont reliés électriquement les uns aux autres et qui sont reliés via une ligne (18, 19, 20) à l'unité d'évaluation (21),
**caractérisé en ce que**
les trajectoires (1, 2, 3, 4) représentent un modèle binaire qui est converti dans l'unité d'évaluation (21) via un tableau de vérité (26) en une valeur numérique indiquant une position.

2. Codeur selon la revendication 1, **caractérisé en ce que** les trajectoires (1, 2, 3, et 4) sont réalisées sur une plaque conductrice (5).

3. Codeur selon la revendication 1 ou 2, **caractérisé en ce que** les trajectoires (1, 2, 3, 4) ont une disposition à symétrie de révolution les unes par rapport aux autres par rapport à un axe A dans un plan.

4. Codeur selon au moins une des revendications 1 à 3, **caractérisé en ce que** les doigts de contact (12) ont une disposition rotative autour de l'axe A de telle sorte qu'ils sont en mesure de passer sur les trajectoires (1, 2, 3, 4), sachant qu'un doigt de contact (12) est respectivement attribué à une trajectoire (1, 2, 3, 4).

5. Codeur selon au moins une des revendications 1 à 4, **caractérisé en ce que** les doigts de contact (12) sont disposés sur une fourchette de contact (11) et la fourchette de contact (11) sur un élément d'entraînement (13) qui est rotatif autour de l'axe A.

6. Codeur selon au moins une des revendications 1 à 5, **caractérisé en ce que** des crans (17) sont prévus permettant un mouvement progressif de l'élément d'entraînement (13), de sorte que les doigts de contact (12) sont avancés à chaque crantage d'un incrément équidistant d'angle de rotation et, ce faisant, prennent respectivement les positions définies au préalable sur les trajectoires (1, 2, 3 et 4).

7. Codeur selon au moins une des revendications 1 à 6, **caractérisé en ce que** les champs de contact (6, 22, 23, 24, 25) sont disposés sur les trajectoires (1, 2, 3 et 4) selon un tableau de vérité (26) défini au préalable.

8. Codeur selon au moins une des revendications 1 à 7, **caractérisé en ce que** quatre trajectoires (1, 2, 3, 4) et quatre doigts de contact (12) sont prévus, sachant que trois trajectoires (1, 2, 3) comportent respectivement des champs de contact (6) qui sont reliés électriquement les uns aux autres et une trajectoire (4) est prévue comportant quatre champs de contact ( 22, 23, 24, 25) qui sont isolés électriquement les uns par rapport aux autres et qui sont chacun reliés respectivement à l'unité d'évaluation (21).

9. Codeur selon au moins une des revendications 1 à 8, **caractérisé en ce que** l'unité d'évaluation (21) avec quatre trajectoires (1, 2, 3, 4) et quatre doigts de contact (12) peut enregistrer 28 positions, sachant qu'une trajectoire (1, 2, 3, 4) représente plusieurs bits.

10. Codeur selon au moins une des revendications 1 à 7, **caractérisé en ce qu'**un générateur de bits est réalisé du fait que les champs de contact (6) des trajectoires (2, 3) sont décalés les uns par rapport aux autres et que l'unité d'évaluation (21) peut à partir de cela enregistrer une rotation à gauche ou à droite.

11. Codeur selon au moins une des revendications 1 à 10, **caractérisé en ce que** le codeur est réalisé comme commutateur rotatif.
